# EUROPEAN PATENT SPECIFICATION

(11) **EP 2 528 110 B1**
(45) Date of publication and mention of the grant of the patent: **09.12.2015**
(21) Application number: 12169246.1
(22) Date of filing: 24.05.2012
(51) Int. Cl.: H01L 31/054

(54) **Photovoltaic system for efficient solar radiation collection and solar panel incorporating same**
Photovoltaiksystem für effiziente Sonnenstrahlungssammlung und Solartafel damit
Système photovoltaïque pour la collecte efficace du rayonnement solaire et panneau solaire incorporant celui-ci

(30) Priority: 26.05.2011 US 201113116769
(43) Date of publication of application: 28.11.2012
(73) Proprietor: Sharp Kabushiki Kaisha, Osaka-shi, Osaka 545-8522 (JP)
(72) Inventor: Rohrmoser, Stefan, Oxford, Oxfordshire OX4 4GB (GB); Mitchell, Sarah Anne, Oxford, OXfordshire OX4 4GB (GB); Montgomery, David James, Oxford, OXfordshire OX4 4GB (GB); Suckling, James Rowland, Oxford, Oxfordshire OX4 4GB (GB)
(74) Representative: Suckling, Andrew Michael

(56) References cited:
- WO-A2-2009/134552
- US-A- 4 053 327
- US-A1- 2010 269 885
- US-A1- 2010 319 773
- US-A1- 2011 005 595

## Description

### TECHNICAL FIELD

The present invention relates to a photovoltaic system for the collection and concentration of solar radiation onto a photovoltaic cell for electrical power generation. More particularly the present invention relates to a photovoltaic system with a primary optical element used to concentrate direct solar radiation onto a secondary structured optical element which condenses the collected radiation onto a photovoltaic cell.

### BACKGROUND ART

Concentrated photovoltaic systems are optical systems which collect the sun's light over a relatively large area and concentrate this light onto a photovoltaic cell of a much smaller surface area commonly consisting of a semiconductor material like silicon, gallium-arsenide or cadmium-telluride. The concentrated sunlight is then converted into electric energy with a certain efficiency by the photovoltaic cell. This approach is very favorable because it allows the price of electricity generated through photovoltaic energy conversion to be reduced by reducing the semiconductor material required, which makes up the biggest part of the cost of the concentrated photovoltaic system. In addition to the concentration ratio, which indicates the saving in semiconductor material for the system, the optical efficiency of the concentration optics is important in order to achieve maximum energy conversion efficiency of the system.

A number of different optical concentration systems are currently competing on the market but the most common system uses Fresnel lenses together with secondary concentrators/homogenisers in order to concentrate the collected sunlight onto the photovoltaic cell. Although these systems were developed and improved since the 1980's concentrated photovoltaic systems only recently have managed to become a commercially viable option due to initial low demand, inadequate photovoltaic cell technology and added cost from solar tracking systems. For this reason efficient management of the available light is of crucial importance. Current concentrated photovoltaic systems are lacking in this respect and particularly are missing a mechanism of managing reflected light exiting the system again. This invention addresses this issue.

WO 2009/134552 proposes a high-efficiency lateral multi-junction solar cell that includes planar spectral band splitting micro-optics having a short-pass filter reflecting desired frequencies of light to a reflective mirror combined with spectrally optimised photovoltaic (solar) cells.

US 4053327 proposes a cover slide for a solar cell that comprises a plurality of converging lenses arranged to focus the incident light so that it does not fall on the grid lines of the front electrode of the solar cell.

US 2010/319773 proposes a concentrated photovoltaic (CPV) module that includes a primary optical element that is a square Fresnel lens fixed in position over a CPV cell. A secondary optical element (SOE) is optically coupled to the cell for providing uniform light over the surface of the cell. The SOE has a square, sloping top portion and a truncated pyramid shaped bottom portion that tapers toward the cell. The top portion is formed of angled flat square rings that refract light entering the top portion from the POE. The bottom portion mixes the light using total internal reflection.

### SUMMARY OF INVENTION

As discussed above the most commonly used concentration optics for a concentrated photovoltaic system consists of a primary Fresnel lens concentrator with a small angular acceptance for the collection and focusing of direct sunlight. This concentration lens has the benefits of providing a high quality optical focus of the light and a very thin form factor as well as easily being manufactured in different shapes like cylindrical or circular. However due to the Fresnel lens having only one optically smooth major surface and a second faceted optical surface it is difficult to apply anti reflection coatings to both surfaces which reduces the efficiency of light management. The secondary concentrator commonly used has the shape of a frustum in the circular case and a clipped triangular prism in the cylindrical case. More complex forms like a compound parabolic concentrator are used as well. This secondary concentrator is disposed with the smaller of the two major parallel surfaces on the photovoltaic cell and the larger of the two major parallel surfaces opens towards the Fresnel cell. The Fresnel lens is directing the collected solar radiation towards the secondary concentrator which is designed in such a way as to mix and guide the light towards the photovoltaic cell and provide efficient and uniform illumination of the photovoltaic cell. Although this secondary concentrator is usually glued to the photovoltaic cell, using an index matching glue with a refractive index between the refractive index of the dielectric material of the secondary concentrator and the semiconductor material of the photovoltaic cell, reflection losses occur at these transitional surfaces.

The current invention relates to an optical component in a concentrated photovoltaic system and the management of light reflected back out of the system from the transitional surfaces between the secondary concentrator and the photovoltaic cell, and to a concentrated photovoltaic system including such an optical component. In particular the current invention relates to a secondary light mixing concentrator preferably with the larger of the two parallel primary optical surfaces which faces the primary concentrating Fresnel lens being provided with a non-planar, corrugated surface structure. The non-planar, corrugated surface structure is designed in such a way that it reflects light otherwise being lost out of the system due to reflections below at the transitional surfaces between the secondary light mixing concentrator and the photovoltaic cell back towards the photovoltaic cell. This allows the optical efficiency of the concentrated photovoltaic system to be improved. In addition the corrugated surface structure allows improving management of the light from the periphery of the Fresnel lens and therefore it can improve concentration ratios as well. Furthermore the corrugated surface structure provides additional light mixing which improves uniform illumination of the photovoltaic cell and hence increases reliability and durability of the photovoltaic cell. As a further benefit the light management capacity of the corrugated surface structure can be extended to improve the usage of the diffuse part of the solar radiation which generally is a shortcoming of concentrated photovoltaic systems. Efficient use of the diffuse part of the solar radiation will allow concentrated photovoltaic systems quicker and more widespread market penetration as it enables their commercial use in more areas of the planet where a large part of the solar radiation is made up of diffuse light.

According to an aspect of the invention, a concentrated photovoltaic system includes a photovoltaic cell; a primary light concentrating optic; and a secondary light mixing concentrator. The primary light concentrating optic is arranged to collect solar radiation and concentrate the collected solar radiation towards the secondary light mixing concentrator. The secondary light mixing concentrator is arranged to concentrate the concentrated solar radiation from the primary light concentrating optic towards the photovoltaic cell. The secondary light mixing concentrator includes a dielectric member having first and second primary surfaces, with the second primary surface being in optical contact with the photovoltaic cell and the first primary surface facing the primary light concentrating optic. The first primary surface has a non-planar surface structure configured to redirect light which is reflected at transitional surfaces between the secondary light mixing concentrator and the photovoltaic cell back towards the photovoltaic cell. The non-planar surface structure is a corrugated surface structure.

In accordance with another aspect, the corrugated surface structure includes prismatic surface structures which are identical.

According to yet another aspect, the corrugated surface structure includes prismatic surface structures having sizes which vary over the first primary surface.

In yet another aspect, the corrugated surface structure includes prismatic surface structures, and a distance between adjacent ones of the prismatic surface structures changes over the first primary surface.

According to still another aspect, the corrugated surface structure includes prismatic surface structures having apex angles that change over the first primary surface.

In accordance with another aspect, the corrugated surface structure includes asymmetric prismatic surface structures.

According to another aspect, the corrugated surface structure includes non-prismatic surface structures.

In yet another aspect, the non-prismatic surface structures include rounded apexes.

With still another aspect, a degree of rounding of the rounded apexes changes over the first primary surface.

In still another aspect, the dielectric member includes a dielectric sheet with the corrugated surface structure laminated onto a planar dielectric slab.

According to another aspect, the secondary light mixing concentrator has one of a rectangular, a regular polygonic, an elliptic or a circular shape.

According to still another aspect, relative to one another the first primary surface is a larger primary surface and the second primary surface is a smaller primary surface.

In yet another aspect, at least one of the side walls of the dielectric member deviates from a linear shape.

According to another aspect, the at least one side wall includes a concave or convex shape.

According to yet another aspect, the system further includes a receptacle formed by a set of side walls and bottom plate in which the photovoltaic and secondary light mixing concentrator are located, the set of side walls being parallel, tapered, concave or convex.

In still another aspect, the system further includes a receptacle formed by a set of side walls and bottom plate in which the photovoltaic cell and secondary light mixing concentrator are located, and shaped mirror structures on the bottom plate to more efficiently direct diffuse solar radiation to the photovoltaic cell.

According to another aspect, the primary light concentrating optic includes a Fresnel lens.

In accordance with another aspect, a solar panel is provided that includes a plurality of concentrated photovoltaic systems of the first aspect.

To the accomplishment of the foregoing and related ends, the invention, then, comprises the features hereinafter fully described and particularly pointed out in the claims. The following description and the annexed drawings set forth in detail certain illustrative embodiments of the invention. These embodiments are indicative, however, of but a few of the various ways in which the principles of the invention may be employed. Other objects, advantages and novel features of the invention will become apparent from the following detailed description of the invention when considered in conjunction with the drawings.

### BRIEF DESCRIPTION OF DRAWINGS

In the annexed drawings, like references indicate like parts or features:
Fig. 1: shows an example of a concentrated photovoltaic system for photovoltaic energy generation constituting the prior art.
Fig. 2a: a schematic of a primary embodiment of the current invention of a highly efficient concentrated photovoltaic system for photovoltaic energy generation.
Fig. 2b: a detailed partial schematic of the secondary light mixing concentrator with prismatic surface structures on its primary surface.
Fig. 2c: a partial perspective view of the current invention of a highly efficient concentrated photovoltaic system for photovoltaic energy generation according to the embodiment of Figs. 2a-2c.
Fig. 3: a schematic of an alternative embodiment of the current invention more generally with a primary light concentrating optic.
Figs. 4a-4c: different embodiments of the secondary light mixing concentrator in accordance with the current invention.
Figs. 5a-5b: different cross sectional shapes of the secondary light mixing concentrator in accordance with the current invention.
Figs. 6a-6c: different shapes and arrangements of the cross sectional shape of the side walls and the bottom plate of a concentrated photovoltaic system in accordance with the current invention.
Figs. 7a-7e: different geometrical shapes and arrangements of the surface relief structure on the primary surface of the secondary light mixing concentrator in accordance with the current invention.
Fig. 8: a schematic of an alternative embodiment of the current invention with a laminated Fresnel lens structure and a sheet carrying surface relief structures laminated onto the primary surface of the secondary light mixing concentrator.
Figs. 9a-9c: schematics of alternative embodiments of the current invention with shaped mirror structures on the bottom plate of the system.
Fig. 10: a perspective view of a solar panel incorporating an array of concentrated photovoltaic systems in accordance with the current invention. structures laminated onto the primary surface of the secondary light mixing concentrator.

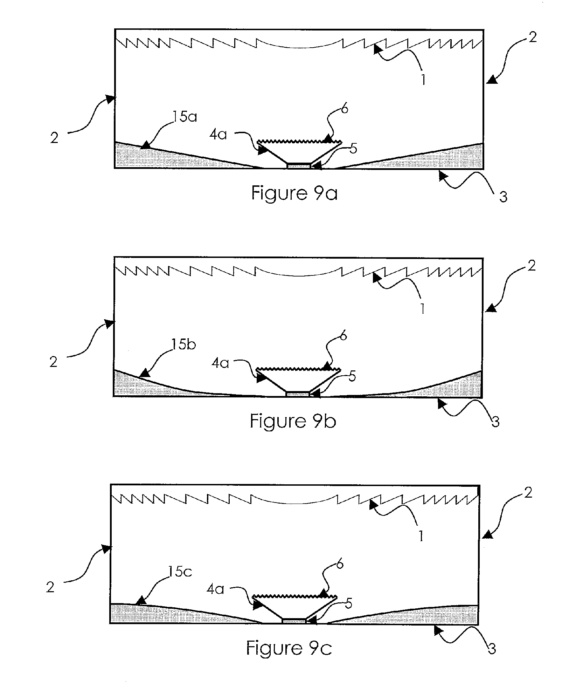

Figs. 9a-9c: schematics of alternative embodiments of the current invention with shaped mirror structures on the bottom plate of the system.

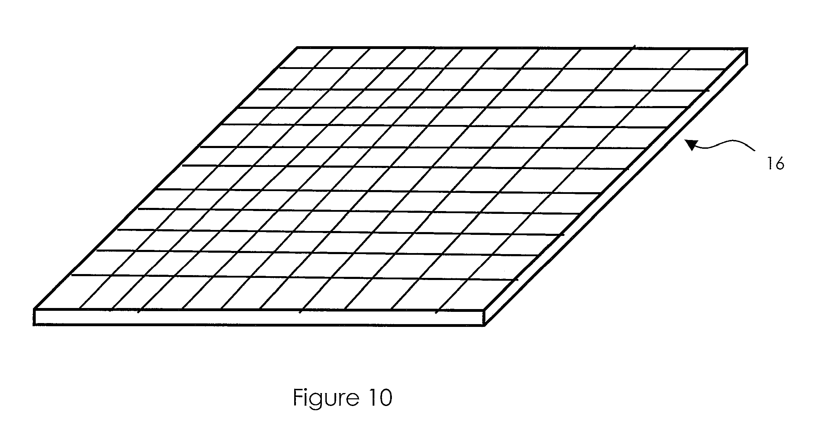

Fig. 10: a perspective view of a solar panel incorporating an array of concentrated photovoltaic systems in accordance with the current invention.

### DESCRIPTION OF REFERENCE NUMERALS

- 1: Fresnel lens
- 2: side walls
- 2a-2c: different embodiments of the side walls of the system
- 3: bottom plate
- 4: secondary light mixing concentrator
- 4a-4e: different embodiments of the secondary light mixing concentrator
- 5: photovoltaic cell
- 6: prismatic surface structures on the primary surface of the light mixing concentrator
- 6a-6g: different possible embodiments of the prismatic surface structures on the light mixing concentrator's primary surface
- 7: primary light concentrating optic
- 8a-8e: different possible embodiments of the apex angle of the prismatic surface structures on the primary surface of the secondary light mixing concentrator
- 9a-9c: different distances between the prismatic surface structures
- 10a-10e: different embodiments of the prismatic surface structure that can deviate from a symmetric shape
- 11a-11b: angles defining the shape of the prismatic surface structures
- 12a-12d: different embodiments of the prismatic surface structure that can deviate from a rectilinear shape
- 13: transparent dielectric slab to allow lamination of the Fresnel lens onto
- 14: sheet with prismatic surface structures laminated onto the secondary light mixing concentrator
- 15a-15c: shaped mirror structures on the bottom plate of the system
- 16: solar panel incorporating array of concentrated photovoltaic systems

### DETAILED DESCRIPTION OF INVENTION

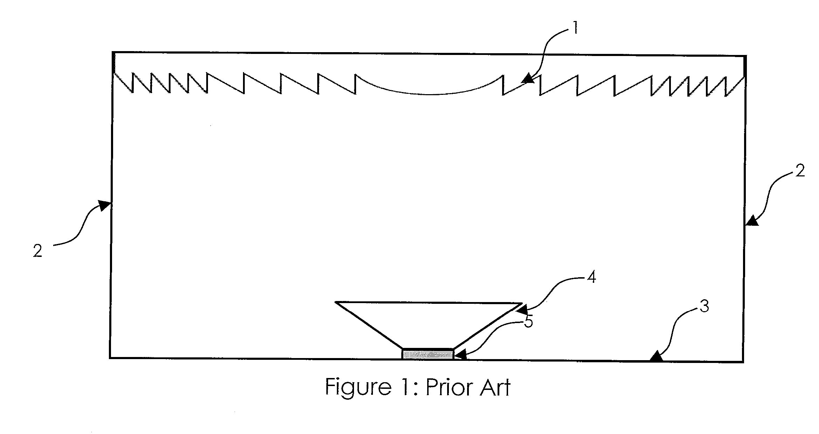

In the following we provide an explicit description of the current invention. For this purpose we use the provided drawings in which reference numerals identify similar or identical elements throughout several views. Fig. **1** represents, in a schematic cross sectional view, a concentrated photovoltaic system which represents the prior art. A set of side walls **2** and a bottom plate **3** form a receptacle which holds the other optical and electrical elements. Without loss of generality we only show two of the side walls **2** in cross sectional views throughout the figures. The side walls **2** and bottom plate **3** are made of a light weight material which can include but is not limited to plastic materials, glass or thin metal sheets. Furthermore the side walls **2** and bottom plate **3** can consist of a number of materials or compound materials and they can be either self-supporting or mounted with the help of a or several supporting structures. The top of the receptacle formed by the set of side walls **2** and bottom plate **3** is covered by a Fresnel lens **1**. Although we focus in the description of the invention on embodiments using side walls **2**, other embodiments without side walls **2** or with a supporting structure replacing the supporting function of the side walls **2** are covered by the current invention as well. The Fresnel lens **1** is either of the plano-convex type or it is a compound Fresnel lens with an unstructured convex or concave second major surface. Without loss of generality we depict the Fresnel lens **1** to be of the plano-convex type throughout the figures of this invention. This Fresnel lens **1** is mounted in a way so that the structured surface is facing inward and the unstructured surface is facing outward. Direct solar radiation, which has a small angular spread, is collected by the Fresnel lens **1** and then concentrated towards the secondary light mixing concentrator **4**. The secondary light mixing concentrator **4** is made of an optically transparent dielectric member which can have the shape of a frustum, a clipped cone, a clipped triangular prism or more complicated shapes like a compound parabolic concentrator, etc. Without loss of generality, the secondary light mixing concentrator **4** is depicted throughout this document as a clipped triangular prism with at least one tapered side surface so that one of the two parallel primary surfaces (e.g., a first primary surface) is larger than the other primary surface (e.g., a second primary surface). The light entering the secondary light mixing concentrator **4** is then concentrated towards the photovoltaic cell **5** which is positioned on the smaller primary parallel surface of the secondary light mixing concentrator **4**. The light then exits the second primary parallel surface of the secondary light mixing concentrator **4** and then the light will mainly be absorbed by the photovoltaic cell **5**. Although the description of the prior art in this text and depicted in Fig. **1** is simplified and ignores the process of the energy conversion and related elements of the system, it does contain all relevant elements and processes needed for the description of the current invention.

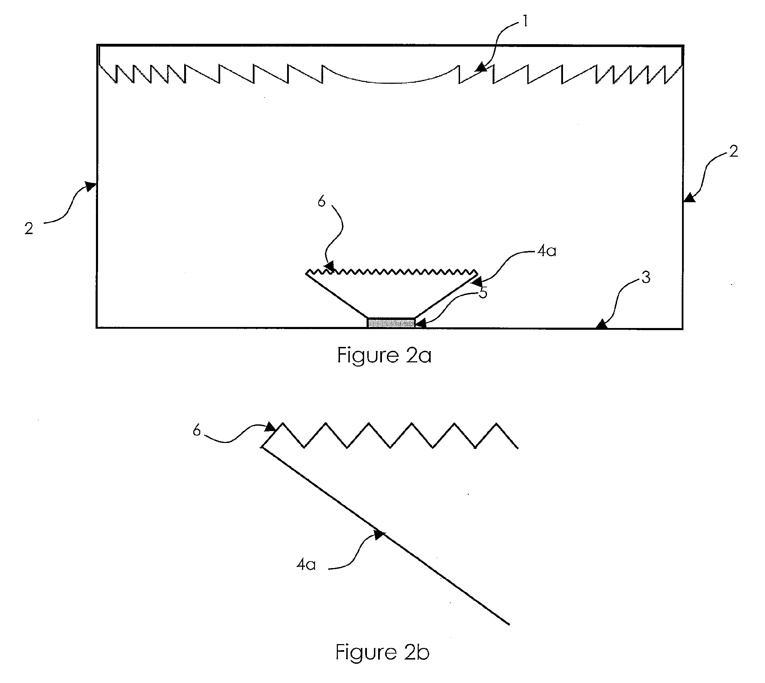

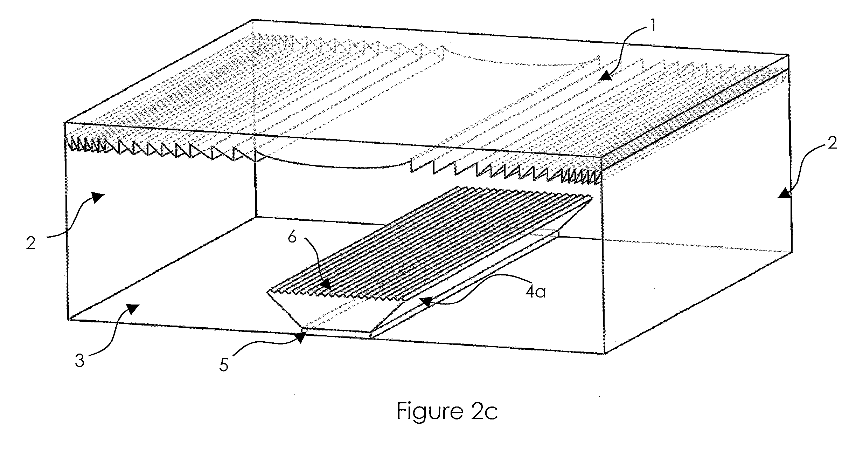

Fig. **2a** shows a schematic cross sectional view of a primary embodiment of a concentrated photovoltaic system in accordance with the current invention; Fig. **2b** provides a close up view of part of the current invention; and Fig. **2c** provides a partial perspective view of the embodiment of Fig. **2a**. The depicted concentrated photovoltaic system uses a Fresnel lens **1** as primary concentrator to collect the direct solar radiation over a relatively large area and then concentrate the light towards the photovoltaic cell **5** with a relatively small area. Before reaching the photovoltaic cell **5** the light is concentrated and mixed by the secondary light mixing concentrator **4a** which is positioned on top of the photovoltaic cell **5** and in optical contact with the photovoltaic cell **5**. The secondary light mixing concentrator **4a** differs from the secondary light mixing concentrator **4** (Fig. **1**) in the prior art at least in part because of prismatic surface structures **6** on the larger primary surface of the secondary light mixing concentrator **4a** which faces the Fresnel lens **1** concentrator. Although in this first embodiment we describe the prismatic surface structures **6** as a set of isosceles triangles, variations of this prismatic shape as well as other non-prismatic shapes which provide a corrugated surface structure that deviates from a flat larger primary surface of the secondary light mixing concentrator **4a** are considered within the scope of the current invention. The light collected by the Fresnel lens **1** and concentrated towards the photovoltaic cell **5** transverses the secondary light mixing concentrator **4a** and exits it at the smaller primary surface to be absorbed by the photovoltaic cell **5**. Some of the light however is reflected back at the transitional surfaces between the secondary light mixing concentrator **4a** and the photovoltaic cell **5**. This light ordinarily would be lost from the system, however the prismatic surface structures **6** are configured to redirect part of this reflected light back towards the photovoltaic cell **5** and hence improving the optical efficiency of the system. In addition to concentrating the light, the secondary light mixing concentrator **4a** has as well the function of mixing the light before it arrives at the photovoltaic cell **5** in order to provide uniform illumination of its surface and improve its lifetime. The prismatic surface structures **6** further enhance the light mixing effect due to their providing a deviation from a flat larger primary surface of the secondary light mixing concentrator **4a** and therefore breaking up the focusing provided by the Fresnel lens **1** and enabling a more uniform illumination of the photovoltaic cell **5**. In the description of the primary embodiment we assumed a linear geometry using a cylindrical Fresnel lens **1** and linear prismatic surface structures **6**; however the embodiments covered by the current invention are not limited to that. In particular circular Fresnel lenses and concentric circular prismatic surface structures, double sided Fresnel lenses, different primary concentration optics and other conceivable geometries are considered within the scope of the current invention as well.

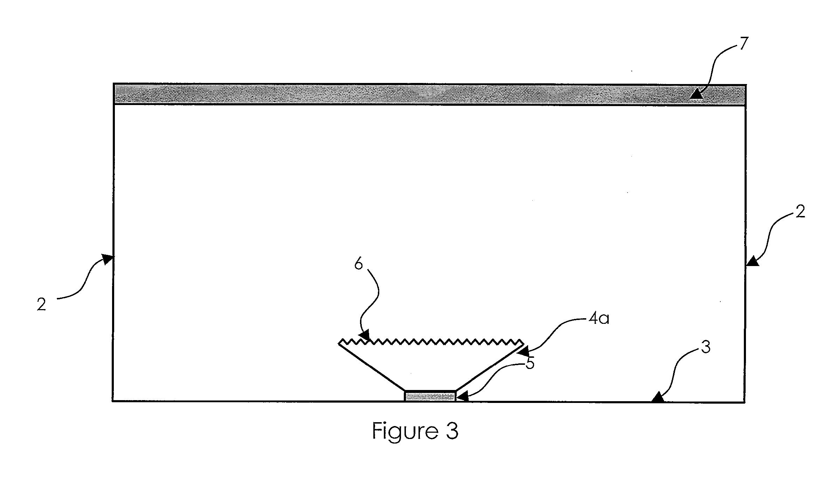

Fig. **3** shows a schematic cross section of a second embodiment of the current invention which differs from the primary embodiment in so far as it does not use a Fresnel lens **1** for the primary concentration optics but instead has another primary light concentrating optic **7**. The depiction of the primary light concentrating optic **7** in Fig. **3** is general and the current invention covers any primary light concentrating optic **7** using refraction, reflection, total internal reflection or a mixture of these processes. Furthermore the current invention is not limited to a primary light concentrating optic **7** consisting only of a single element, but an assembly of a number of elements constituting the primary light concentrating optic **7** is also within the scope of the current invention.

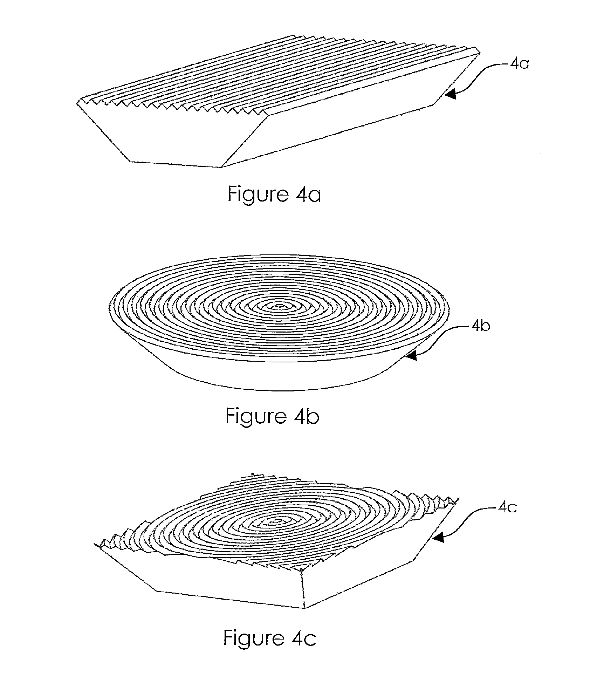

The depiction of embodiments of the current invention focuses on linear arrangements of the Fresnel lens **1**; however embodiments covered by the current invention are not limited to that. In Fig. **4a** a three dimensional view of a rectangular secondary light mixing concentrator **4a** used in the linear concentrated photovoltaic system is shown. Figs. **4b** and **4c** show three dimensional views of alternative embodiments of the secondary light mixing concentrator **4b** and **4c** respectively which are to be used in a circular (for Fig. **4b**) or a square (for Fig. **4c**) geometry of the concentrated photovoltaic system. Figs. **4a**, **4b** and **4c** represent the preferred embodiments of the current invention in which the secondary light mixing concentrator structures **6** include a number of parallel or concentric prismatic surface structures. Without loss of generality, however, other system geometries (e.g., regular polygonic, elliptical, etc.) and surface structure arrangements are intended to be within the scope of the current invention as well.

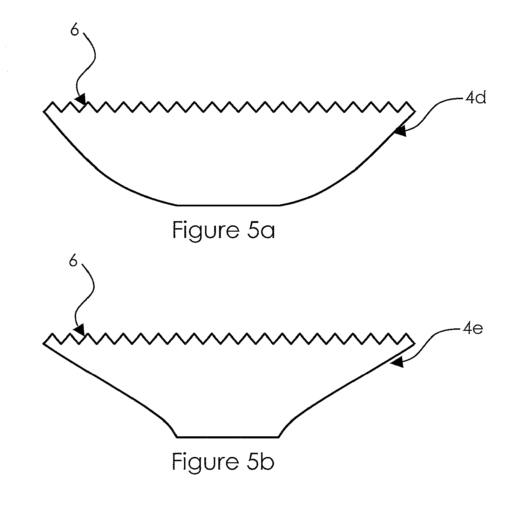

In the earlier figures we consistently depicted the secondary light mixing concentrator **4a** with straight side walls; however the current invention is not limited to that. In Figs. **5a** and **5b** cross sectional views of different embodiments of the secondary light mixing concentrator, **4d** and **4e** respectively, are shown with convex and concave side walls respectively. The side walls deviate from a linear shape and function mainly as total internal reflection surfaces.

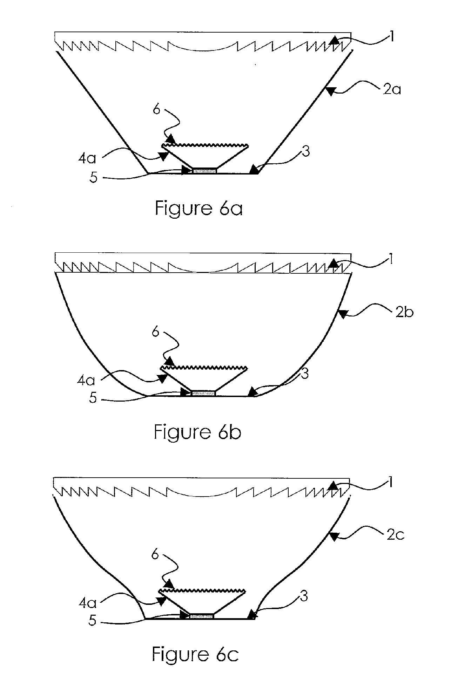

In the earlier figures of the concentrated photovoltaic system we consistently depicted the side walls **2** as being straight and parallel; however embodiments of the current invention are not limited to this. In Figs. **6a, 6b** and **6c** different embodiments of the concentrated photovoltaic system with tapered side walls **2a,** concave side walls **2b** and convex side walls **2c** are respectively shown. The current invention includes these embodiments but is not limited to them and the shape of the side walls will depend on the application, location and geometry of the concentrated photovoltaic system.

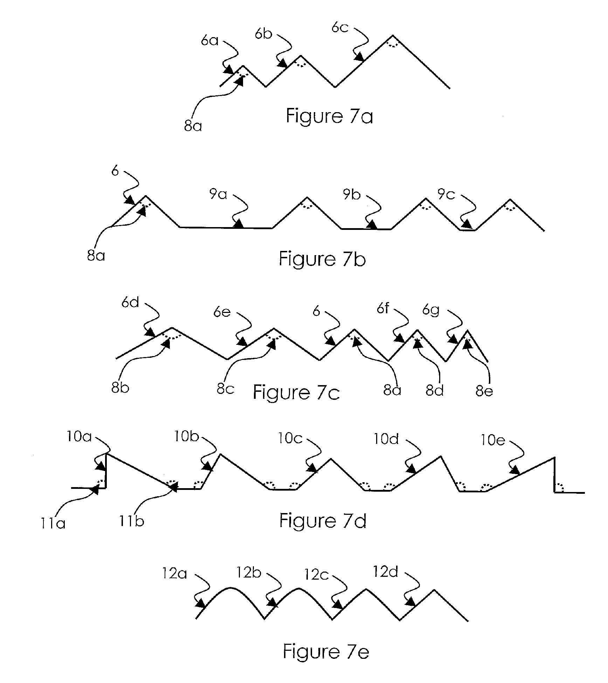

In the earlier depictions of the prismatic surface structures **6** on the primary surface of the secondary light mixing concentrator **4a** facing the Fresnel lens **1** the prismatic surface structures **6** are shown as being symmetric and identical over the whole surface. However, the current invention is not limited to a symmetrically and identically shaped prismatic surface structure **6.** In the following figures we introduce views of additional embodiments of the prismatic surface structures **6,** the views are detailed and exemplary and hence other parts of the concentrated photovoltaic system are omitted in the figures. In Fig. **7a** we show an additional embodiment of the prismatic surface structures **6a, 6b** and **6c** where the structures vary in size over the primary surface of the secondary light mixing concentrator. Although the size of the structures changes the apex angle **8a** stays the same in this exemplary embodiment. The variation in size is not limited to a linear variation. In Fig. **7b** an additional embodiment of the arrangement of the prismatic surface structures **6** is shown with the distance **9a, 9b,** and **9c** between individual adjacent prismatic surface structures **6** changing over the surface. The change of the distance between individual prismatic surface structures **6** is not limited to being linear and the distance may be allowed to vanish so that adjacent prismatic surface structures **6** touch. Fig. **7c** represents an additional embodiment of the structured primary surface of the secondary light mixing concentrator **4a** with changing apex angles **8a - 8e** of the prismatic surface structures **6, 6d - 6g** over the extent of the primary surface of the secondary light mixing concentrator **4a.** In Fig. **7d** additional embodiments of the prismatic surface structures **10a** - **10e** are shown. The prismatic surface structures **10a** - **10e** are asymmetric, with the exception of **10c**, and the prismatic surface structures **10a** - **10e** are characterised by the angles **11a** and **11b,** for example, which deteremine the symmetry of the prismatic surface structures **10a** - **10e** as well. Fig. **7e** depicts another embodiment of surface structures **12a** - **12d** with the surface structure deviating from the geometrical prism shape with straight lines and having a rounded apex. A degree of rounding of the apex may change over the extent of the primary surface. All the embodiments of surface structures depicted in Figs. **7a - 7e** may be used on the same secondary light mixing concentrator **4a** for the same concentrated photovoltaic system. Although the depictions in fig. **7a - 7e** focus on prismatic surface structures the embodiments covered by this invention are not limited to prismatic shapes only.

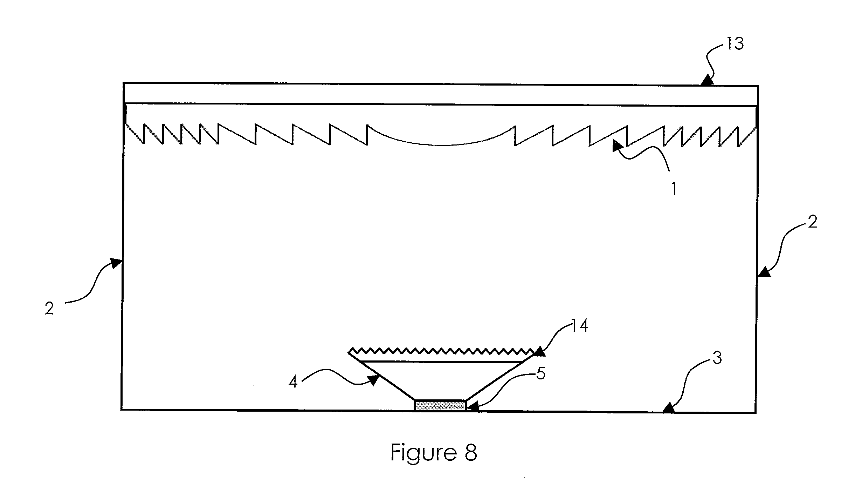

Fig. **8** shows an additional embodiment of a concentrated photovoltaic system covered by the current invention. State of the art manufacture includes extrusion and injection mold processes, however these processes are often not precise enough in order to manufacture small structures with high tolerance and repeatability. Therefore, embossing and reel to reel manufacture of thin films is often used for the manufacture of precision optical sheets. The manufacture of the surface features and the Fresnel lens **1** within the scope of the invention can be achieved by these processes as well. The resulting Fresnel lens **1** can be laminated onto a planar transparent dielectric slab **13,** and similarly a dielectric sheet with prismatic surface structures **14** can be laminated onto a dielectric slab to form the secondary light mixing concentrator **4.** In this way the two optical concentrators of the resulting concentrated photovoltaic system are produced without requiring extrusion or injection mold processing.

The concentrated photovoltaic systems explained in the earlier figures are designed to efficiently concentrate direct solar radiation onto the photovoltaic cell **5.** However, a large part of the solar radiation reaching the earth's surface consists of diffuse solar radiation. The earlier described embodiments have no efficient means of collecting this diffuse solar radiation. In Figs. **9a - 9c** embodiments of the current invention are shown that incorporate shaped mirror structures **15a - 15c** on the bottom plate **3** which allow the concentrated photovoltaic system to efficiently direct diffuse solar radiation to the photovoltaic cell **5;** however this embodiment is not limited to diffuse solar radiation but also direct solar radiation directed onto the shaped mirror structures **15a - 15c** is within the scope of the current invention.

**Fig. 10** illustrates a solar panel **16** in accordance with the current invention which incorporates an array of concentrated photovoltaic systems formed in accordance with any of the embodiments described above. As will be appreciated, the electrical outputs of the photovoltaic cells may be combined so as to provide overall power generation within a solar power generating system.

The present invention has been described herein primarily in the context of a preferred embodiment in which the primary surface of the secondary light mixing concentrator facing the primary light concentrating optic has a corrugated surface structure configured to redirect light which is reflected at transitional surfaces between the secondary light mixing concentrator and the photovoltaic cell back towards the photovoltaic cell.

Further, the present invention has been described herein in terms of the secondary light mixing concentrator 4 concentrating the concentrated light from the primary light concentrating optic towards the photovoltaic cell. In the broadest sense of the invention (e.g., where the first and second primary surfaces of the dielectric member may be of the same size), it will be understood that the concentration ratio of the secondary light mixing concentrator may be 1:1. In a preferred embodiment, the secondary light mixing concentrator 4 has a concentration ratio greater than 1 (e.g., where the first and second primary surfaces of the dielectric member are larger and smaller, respectively, relative to one another).

Although the invention has been shown and described with respect to a certain embodiment or embodiments, equivalent alterations and modifications may occur to others skilled in the art upon the reading and understanding of this specification and the annexed drawings. In particular regard to the various functions performed by the above described elements (components, assemblies, devices, compositions, etc.), the terms (including a reference to a "means") used to describe such elements are intended to correspond, unless otherwise indicated, to any element which performs the specified function of the described element (i.e., that is functionally equivalent), even though not structurally equivalent to the disclosed structure which performs the function in the herein exemplary embodiment or embodiments of the invention. In addition, while a particular feature of the invention may have been described above with respect to only one or more of several embodiments, such feature may be combined with one or more other features of the other embodiments, as may be desired and advantageous for any given or particular application.

### INDUSTRIAL APPLICABILITY

The current invention relates to the generation of electricity by converting concentrated solar radiation into electricity using photovoltaic cells. In particular the current invention relates to an optical arrangement which allows for very efficient concentration of solar radiation onto a photovoltaic cell and a modular large scale concentrated photovoltaic system making use of the optical arrangement. The current invention can be used by photovoltaic cell manufacturers to package high efficiency photovoltaic cells into the described large concentration optics package. Photovoltaic system developers and companies running large scale photovoltaic power plants can exploit the current invention to reduce cost by using the described optical mechanism to make more efficient use of the collected solar radiation. The current invention can be used in combination with single and double axis solar tracking systems.

## Claims

1. A concentrated photovoltaic system, comprising:
a photovoltaic cell (5);
a primary light concentrating optic (1,7); and
a secondary light mixing concentrator (4),
wherein the primary light concentrating optic (1,7) is arranged to collect solar radiation and concentrate the collected solar radiation towards the secondary light mixing concentrator (4),
the secondary light mixing concentrator (4) is arranged to concentrate the concentrated solar radiation from the primary light concentrating optic (1,7) towards the photovoltaic cell (5),
the secondary light mixing concentrator (4) includes a dielectric member having first and second primary surfaces, with the second primary surface being in optical contact with the photovoltaic cell (5) and the first primary surface facing the primary light concentrating optic (1,7), and
the first primary surface has a non-planar surface structure (6) **characterized in that** said non-planar surface structure is a corrugated surface structure and is configured to redirect light which is reflected at interfaces between the secondary light mixing concentrator (4) and the photovoltaic cell (5) back towards the photovoltaic cell (5).

2. The concentrated photovoltaic system according to claim 1, wherein the corrugated surface structure includes prismatic surface structures (6) which are identical or which have sizes which vary over the first primary surface.

3. The concentrated photovoltaic system according to claim 1, wherein the corrugated surface structure includes prismatic surface structures (6), and a distance between adjacent ones of the prismatic surface structures changes over the first primary surface.

4. The concentrated photovoltaic system according to claim 1, wherein the corrugated surface structure includes prismatic surface structures (6) having apex angles that change over the first primary surface.

5. The concentrated photovoltaic system according to claim 1, wherein the corrugated surface structure includes either asymmetric prismatic surface structures (6) or non-prismatic surface structures.

6. The concentrated photovoltaic system according to claim 5, wherein the surface structures are non-prismatic surface structures which include rounded apexes.

7. The concentrated photovoltaic system according to claim 6, wherein a degree of rounding of the rounded apexes changes over the first primary surface.

8. The concentrated photovoltaic system according to any one of claims 1-7, wherein the dielectric member (4) includes a dielectric sheet with the corrugated surface structure laminated onto a planar dielectric slab.

9. The concentrated photovoltaic system according to any one of claims 1-8, wherein the secondary light mixing concentrator (4) has one of a rectangular, a regular polygonic, an elliptic or a circular shape.

10. The concentrated photovoltaic system according to any one of claims 1-9, wherein relative to one another the first primary surface is a larger primary surface and the second primary surface is a smaller primary surface.

11. The concentrated photovoltaic system according to any one of claims 1-10, wherein at least one of the side walls of the dielectric member (4) includes a concave or convex shape, or otherwise deviates from a linear shape.

12. The concentrated photovoltaic system according to any one of claims 1-11, further including a receptacle formed by a set of side walls (2) and bottom plate (3) in which the photovoltaic cell (5) and secondary light mixing concentrator (4) are located, the set of side walls being parallel, tapered, concave or convex.

13. The concentrated photovoltaic system according to any one of claims 1-12, further including a receptacle formed by a set of side walls (2) and bottom plate (3) in which the photovoltaic cell (5) and secondary light mixing concentrator (4) are located, and shaped mirror structures on the bottom plate to direct diffuse solar radiation to the photovoltaic cell.

14. The concentrated photovoltaic system according to any one of claims 1-13, wherein the primary light concentrating optic includes a Fresnel lens (1).

15. A solar panel, comprising:
a plurality of the concentrated photovoltaic system according to any one of claims 1-14, arranged in an array.

## Patentansprüche

1. Konzentriertes Fotovoltaiksystem, umfassend:
eine Fotovoltaikzelle (5);
eine Primärlichtkonzentrationsoptik (1, 7); und
einen Sekundärlichtmischungskonzentrator (4),
worin die Primärlichtkonzentrationsoptik (1, 7) dafür eingerichtet ist, Sonnenstrahlung zu sammeln und die gesammelte Sonnenstrahlung auf den Sekundärlichtmischungskonzentrator (4) zu konzentrieren,
wobei der Sekundärlichtmischungskonzentrator (4) dafür eingerichtet ist, die konzentrierte Sonnenstrahlung von der Primärlichtkonzentrationsoptik (1, 7) auf die Fotovoltaikzelle (5) zu konzentrieren,
wobei der Sekundärlichtmischungskonzentrator (4) ein dielektrisches Element mit einer ersten und einer zweiten Primäroberfläche aufweist, wobei die zweite Primäroberfläche in optischem Kontakt mit der Fotovoltaikzelle (5) steht und die erste Primäroberfläche der Primärlichtkonzentrationsoptik (1, 7) zugewandt ist, und
die erste Primäroberfläche eine nicht ebene Oberflächenstruktur (6) hat, die **dadurch gekennzeichnet ist, dass** die nicht ebene Oberflächenstruktur eine geriffelte Oberflächenstruktur ist und dafür konfiguriert ist, Licht, das an Grenzflächen zwischen dem Sekundärlichtmischungskonzentrator (4) und der Fotovoltaikzelle (5) reflektiert wird, zurück zur Fotovoltaikzelle (5) umzulenken.

2. Konzentriertes Fotovoltaiksystem nach Anspruch 1, worin die geriffelte Oberflächenstruktur prismatische Oberflächenstrukturen (6) aufweist, die miteinander identisch sind oder Größen haben, die über die erste Primäroberfläche hinweg variieren.

3. Konzentriertes Fotovoltaiksystem nach Anspruch 1, worin die geriffelte Oberflächenstruktur prismatische Oberflächenstrukturen (6) aufweist und ein Abstand zwischen Benachbarten der prismatischen Oberflächenstrukturen sich über die erste Primäroberfläche hinweg ändert.

4. Konzentriertes Fotovoltaiksystem nach Anspruch 1, worin die geriffelte Oberflächenstruktur prismatische Oberflächenstrukturen (6) mit Öffnungswinkeln aufweist, die sich über die erste Primäroberfläche hinweg ändern.

5. Konzentriertes Fotovoltaiksystem nach Anspruch 1, worin die geriffelte Oberflächenstruktur entweder asymmetrische prismatische Oberflächenstrukturen (6) oder nicht prismatische Oberflächenstrukturen aufweist.

6. Konzentriertes Fotovoltaiksystem nach Anspruch 5, worin die Oberflächenstrukturen nicht prismatische Oberflächenstrukturen sind, die abgerundete Scheitel aufweisen.

7. Konzentriertes Fotovoltaiksystem nach Anspruch 6, worin ein Grad der Abrundung der abgerundeten Scheitel über die erste Primäroberfläche hinweg variiert.

8. Konzentriertes Fotovoltaiksystem nach einem der Ansprüche 1 bis 7, worin das dielektrische Element (4) eine dielektrische Folie aufweist, wobei die geriffelte Oberflächenstruktur auf eine ebene dielektrische Platte laminiert ist.

9. Konzentriertes Fotovoltaiksystem nach einem der Ansprüche 1 bis 8, worin der Sekundärlichtmischungskonzentrator (4) eine von Folgendem hat: eine rechteckige, eine regelmäßig polygonale, eine elliptische oder eine Kreisform.

10. Konzentriertes Fotovoltaiksystem nach einem der Ansprüche 1 bis 9, worin in Bezug aufeinander die erste Primäroberfläche eine größere Primäroberfläche ist und die zweite Primäroberfläche eine kleinere Primäroberfläche ist.

11. Konzentriertes Fotovoltaiksystem nach einem der Ansprüche 1 bis 10, worin mindestens eine der Seitenwände des dielektrischen Elements (4) eine konkave oder konvexe Form aufweist oder anderweitig von einer linearen Form abweicht.

12. Konzentriertes Fotovoltaiksystem nach einem der Ansprüche 1 bis 11, ferner eine Aufnahme aufweisend, die durch eine Menge von Seitenwänden (2) und eine Bodenplatte (3) gebildet wird, in der die Fotovoltaikzelle (5) und der Sekundärlichtmischungskonzentrator (4) angeordnet sind, wobei die Menge von Seitenwänden parallel, verjüngt, konkav oder konvex ist.

13. Konzentriertes Fotovoltaiksystem nach einem der Ansprüche 1 bis 12, ferner aufweisend: eine Aufnahme, die durch eine Menge von Seitenwänden (2) und eine Bodenplatte (3) gebildet wird, in der die Fotovoltaikzelle (5) und der Sekundärlichtmischungskonzentrator (4) angeordnet sind, und geformte Spiegelstrukturen auf der Bodenplatte, um diffuse Sonnenstrahlung zur Fotovoltaikzelle zu lenken.

14. Konzentriertes Fotovoltaiksystem nach einem der Ansprüche 1 bis 13, worin die Primärlichtkonzentrationsoptik eine Fresnellinse (1) aufweist.

15. Solarmodul, umfassend:
eine Vielzahl des konzentrierten Fotovoltaiksystems nach einem der Ansprüche 1 bis 14, die in Serie angeordnet ist.

## Revendications

1. Système photovoltaïque à concentration, comprenant :
une cellule photovoltaïque (5) ;
une optique primaire concentratrice de lumière (1, 7) ; et
un concentrateur secondaire mélangeur de lumière (4),
dans lequel l'optique primaire concentratrice de lumière (1, 7) est agencée pour collecter un rayonnement solaire et concentrer le rayonnement solaire collecté en direction du concentrateur secondaire mélangeur de lumière (4),
le concentrateur secondaire mélangeur de lumière (4) est agencé pour concentrer le rayonnement solaire à concentration en provenance de l'optique primaire concentratrice de lumière (1, 7) en direction de la cellule photovoltaïque (5),
le concentrateur secondaire mélangeur de lumière (4) comprend un élément diélectrique présentant des première et deuxième surfaces primaires, la deuxième surface primaire étant en contact optique avec la cellule photovoltaïque (5) et la première surface primaire faisant face à l'optique primaire concentratrice de lumière (1, 7), et
la première surface primaire présente une structure de surface non plane (6) **caractérisée en ce que** ladite structure de surface non plane est une structure de surface ondulée et est configurée pour rediriger la lumière qui est reflétée au niveau d'interfaces entre le concentrateur secondaire mélangeur de lumière (4) et la cellule photovoltaïque (5) vers l'arrière en direction de la cellule photovoltaïque (5).

2. Système photovoltaïque à concentration selon la revendication 1, dans lequel la structure de surface ondulée comprend des structures de surface prismatiques (6) qui sont identiques ou qui présentent des tailles qui varient sur la première surface primaire.

3. Système photovoltaïque à concentration selon la revendication 1, dans lequel la structure de surface ondulée comprend des structures de surface prismatiques (6), et une distance entre des structures adjacentes parmi les structures de surface prismatiques varie sur la première surface primaire.

4. Système photovoltaïque à concentration selon la revendication 1, dans lequel la structure de surface ondulée comprend des structures de surface prismatiques (6) présentant des angles sommitaux qui varient sur la première surface primaire.

5. Système photovoltaïque à concentration selon la revendication 1, dans lequel la structure de surface ondulée comprend des structures de surface prismatiques asymétriques (6) ou des structures de surface non prismatiques.

6. Système photovoltaïque à concentration selon la revendication 5, dans lequel les structures de surface sont des structures de surface non prismatiques qui comprennent des sommets arrondis.

7. Système photovoltaïque à concentration selon la revendication 6, dans lequel un degré d'arrondissement des sommets arrondis varie sur la première surface primaire.

8. Système photovoltaïque à concentration selon l'une quelconque des revendications 1 à 7, dans lequel l'élément diélectrique (4) comprend une lame diélectrique avec la structure de surface ondulée stratifiée sur une plaque diélectrique plane.

9. Système photovoltaïque à concentration selon l'une quelconque des revendications 1 à 8, dans lequel le concentrateur secondaire mélangeur de lumière (4) présente une forme parmi une forme rectangulaire, polygonale régulière, elliptique ou circulaire.

10. Système photovoltaïque à concentration selon l'une quelconque des revendications 1 à 9, dans lequel, l'une par rapport à l'autre, la première surface primaire est une surface primaire plus grande et la deuxième surface primaire est une surface primaire plus petite.

11. Système photovoltaïque à concentration selon l'une quelconque des revendications 1 à 10, dans lequel au moins une des parois latérales de l'élément diélectrique (4) comprend une forme concave ou convexe, ou s'écarte d'une forme linéaire d'une autre façon.

12. Système photovoltaïque à concentration selon l'une quelconque des revendications 1 à 11, comprenant en outre un réceptacle formé par un ensemble de parois latérales (2) et une plaque de base (3), dans lequel se trouvent la cellule photovoltaïque (5) et le concentrateur secondaire mélangeur de lumière (4), l'ensemble de parois latérales étant parallèles, coniques, concaves ou convexes.

13. Système photovoltaïque à concentration selon l'une quelconque des revendications 1 à 12, comprenant en outre un réceptacle formé par un ensemble de parois latérales (2) et une plaque de base (3), dans lequel se trouvent la cellule photovoltaïque (5) et le concentrateur secondaire mélangeur de lumière (4), et des structures de miroir mises en forme présentes sur la plaque de base afin de diriger un rayonnement solaire diffus vers la cellule photovoltaïque.

14. Système photovoltaïque à concentration selon l'une quelconque des revendications 1 à 13, dans lequel l'optique primaire concentratrice de lumière comprend une lentille de Fresnel (1).

15. Panneau solaire, comprenant :
une pluralité de systèmes photovoltaïques à concentration selon l'une quelconque des revendications 1 à 14, agencés en un réseau.
